# EUROPEAN PATENT APPLICATION

(11) **EP 4 297 095 A1**
(43) Date of publication of application: **27.12.2023**
(21) Application number: 22180717.5
(22) Date of filing: 23.06.2022
(51) Int. Cl.: H01L 29/04, H01L 29/06, H01L 29/66, H01L 29/775, H01L 21/02, H01L 27/088, B82Y 10/00

(54) **MULTIFACETED SEMICONDCUTOR DEVICE FOR A GATE-ALL-AROUND INTEGRATED DEVICE**

(71) Applicant: Huawei Technologies Co., Ltd., Shenzhen, Guangdong 518129, (CN)
(72) Inventor: BHUWALKA, Krishna Kumar, 80992 Munich (DE); HORIGUCHI, Naoto, 3001 Leuven (BE); LOO, Roger, 3001 Leuven (BE)
(74) Representative: Roth, Sebastian

(57) **Abstract**

This disclosure relates to semiconductor devices for integrated devices like nanosheet devices, forksheet devices, or complementary field effect transistor devices. The semiconductor device comprises a substrate layer (101, 102) and a semiconductor structure arranged partly in a trench formed in the substrate layer and partly protruding from the trench. The protruding end of the semiconductor structure is formed by at least a first and a second facet (103, 104) of the semiconductor material of the semiconductor structure, which are arranged at an angle to each other. A first layer stack (105) and a second layer stack (106) are arranged on the protruding end, each comprising one or more first semiconductor layers and one or more second semiconductor layers stacked in an alternating manner. The first layer stack is arranged on the first facet and the second layer stack is arranged on the second facet.The first and second steps may adjoin are may be separated.

## Description

### TECHNICAL FIELD

The present disclosure relates to a semiconductor device, for example, for an integrated device comprising the semiconductor device. The integrated device may be a nanosheet device, or a forksheet device, or a complementary field effect transistor (CFET) device. The semiconductor device comprises a multifaceted semiconductor structure with a multifaceted layer stack, wherein the multifaceted layer stack form a FET structure.

### BACKGROUND

An integrated device comprising a transistor structure can be provided with an improved device performance by increasing an effective transistor width. This can be achieved by using a stack of a plurality of semiconductor nanosheet channel layers. The effective transistor width depends on the channel widths and channel heights of each of the nanosheet channel layers, and depends on the total number of nanosheet channel layers that are used.

Accordingly, one way to increase the effective transistor width is to increase the number of nanosheet channel layers. However, this number is limited by the sheet efficiency of the first nanosheet channel layer of the stack.

Another way to increase the effective transistor width is to increase the respective channel widths of the stacked nanosheet channel layers. However, conventionally, (100) nanosheet channel layers are arranged on a (100) substrate, which limits the maximum channel width.

### SUMMARY

In view of the above, this disclosure aims to increase the effective transistor width in a semiconductor device in a different way. At the same time, however, a goal of the disclosure is also to not significantly increase the total height of the stack. A further goal of the disclosure is to provide an integrated device with an improved performance based on the semiconductor device.

The above can be achieved by the solutions described in the independent claims. Advantageous implementations are defined in the dependent claims.

A first aspect of this disclosure provides a semiconductor device comprising: a substrate layer; a semiconductor structure arranged partly in a trench formed in the substrate layer and partly protruding from the trench, wherein a protruding end of the semiconductor structure is formed by at least a first facet and a second facet of a semiconductor material of the semiconductor structure, wherein the first facet and the second facet are arranged at an angle to each other; and a first layer stack and a second layer stack arranged on the protruding end of the semiconductor structure, wherein the first layer stack and the second layer stack each comprise one or more first semiconductor layers and one or more second semiconductor layers stacked in an alternating manner, and wherein the first layer stack is arranged on the first facet and the second layer stack is arranged on the second facet of the protruding end of the semiconductor structure.

The protruding end of the semiconductor structure may be formed by more than two facets, wherein in this case the three or more facets are each arranged at an angle to another. The first layer stack may be a first epitaxial layer stack (grown with epitaxy) and the second layer stack may be a second epitaxial layer stack.

By forming the layers stacks on at least the first facet and the second facet of the two or more facets of the semiconductor structure, the effective transistor width of a transistor formed based on the first semiconductor layers (e.g., sacrificial layers) and the second semiconductor layers (e.g., channel layers ) can be increased without increasing the number of stacked layers and without significantly increasing the height of the stacks in stacking direction of the layers. Accordingly, with the semiconductor device of the first aspect, an integrated device with an improved performance can be designed.

In an implementation form of the first aspect, the first facet and the second facet are both {111} crystal facets or are both {311} crystal facets of the semiconductor material of the semiconductor structure.

In case that the protruding end of the semiconductor structure is formed by more than two facets, for instance, a third facet and a fourth facet may both be {111} crystal facets (if the first facet and the second facet are both {311} crystal facets) or may both be {311} crystal facets (if the first facet and the second facet are both {111} crystal facets). These kind of facets enable high-quality epitaxial growth of the first and second semiconductor layers.

In an implementation form of the first aspect, the first facet and the second facet are adjoining at a common edge and/or form a tip of the protruding end of the semiconductor structure.

The first facet and second facet may thus be in direct contact with each other. If there is a third facet, the third facet may be adjoining either the first facet or the second facet at a common edge. If there is additionally a fourth facet, the fourth facet may be also adjoining either the first facet or the second facet (e.g., the facet that the third facet is not adjoining) at another common edge. For example, the third facet may have a common edge with the first facet. The first facet may have this common edge with the third facet, and may have another common edge with the second facet. Finally, the fourth facet may have yet another common edge with the second facet. Thus, the four facets can be arranged adjoining in an order third facet, first facet, second facet, fourth facet. For example, the protruding end of the semiconductor structure may thus have an angled shape, for instance, a triangular-like shape.

In an implementation form of the first aspect, the two or more semiconductor layers of the first layer stack and the two or more semiconductor layers of the second layer stack are, respectively, adjoining each other and form a first multifaceted layer stack, which comprises one or more first multifaceted semiconductor layers and one or more second multifaceted semiconductor layers stacked in an alternating manner.

Such a multifaceted layer stack can be efficiently grown with high quality on each of at least the first facet and the second facet (optionally a third or further facet) simultaneously.

In an implementation form of the first aspect, the semiconductor device further comprises a multifaceted semiconductor spacer layer arranged on the first multifaceted layer stack, and a second multifaceted layer stack arranged on the multifaceted spacer layer, wherein the second multifaceted layer stack comprises one or more first multifaceted semiconductor layers and one or more second multifaceted semiconductor layers stacked in an alternating manner.

In this way, the semiconductor device is suitable for forming a CFET device.

In an implementation form of the first aspect, the semiconductor device further comprises a dielectric material that separates the first facet and the first layer stack from the second facet and the second layer stack.

Thus, the first facet and the second facet are not in direct contact with each other.

In an implementation form of the first aspect, the first semiconductor layers are made of silicon germanium, and the second semiconductor layers are made of silicon; or the first semiconductor layers are made of silicon germanium with a first germanium content, and the second semiconductor layers are made of silicon germanium with a second germanium content different from the first germanium content.

In an implementation form of the first aspect, the first multifaceted semiconductor layers are made of silicon germanium with a germanium content in a range of 15-20%, and the multifaceted semiconductor spacer layer is made of silicon germanium with a germanium content in a range of 25-50%.

This is beneficial for further integrating the semiconductor device into a CFET device. The second multifaceted semiconductor layers may be made of silicon.

In an implementation form of the first aspect, the semiconductor structure is made of crystalline silicon.

The semiconductor structure may be an epitaxial structure, which is epitaxially grown. Other material systems are possible, for example, a III-V semiconductor material system.

In an implementation form of the first aspect, the substrate layer comprises silicon oxide.

Other substrate layer materials, for instance, other oxides or materials based on a different semiconductor material system are possible.

In an implementation form of the first aspect, the semiconductor device further comprises a dielectric layer, which covers the outer surfaces of respectively the protruding part of the semiconductor structure and each layer stack.

In an implementation form of the first aspect, the semiconductor device further comprises a gate structure arranged on the substrate layer and surrounding part of the semiconductor structure that protrudes from the trench and each layer stack.

In this way, a gate all around structure can be formed.

A second aspect of this disclosure provides an integrated device comprising a semiconductor device, wherein: the integrated device is a nanosheet device; or the integrated device is a forksheet device; or the integrated device is a complementary field effect transistor (CFET) device.

The integrated device of the second aspect may have an improved device performance, which is achieved due to the increased transistor width enabled by the semiconductor device.

A third aspect of this disclosure provides a method for fabricating a semiconductor device, the method comprising: forming a substrate layer and a trench in the substrate layer; forming a semiconductor structure at least partly in the trench, wherein the semiconductor structure has a free end formed by at least a first facet and a second facet of a semiconductor material of the semiconductor structure; and epitaxially growing a multifaceted layer stack on the first facet and the second facet of the free end of the semiconductor structure, wherein the multifaceted layer stack comprises one or more first multifaceted semiconductor layers and one or more second multifaceted semiconductor layers stacked in an alternating manner.

In an implementation form of the third aspect, the multifaceted layer stack is formed within the trench on the free end of the semiconductor structure; or the multifaceted layer stack is formed on the free end, which protrudes from the trench.

In an implementation form of the third aspect, the method further comprises etching into the multifaceted layer stack and into the semiconductor structure to completely separate the multifaceted layer stack into a first layer stack and a second layer stack arranged on, respectively, the first facet and the second facet, wherein the first layer stack and the second layer stack each comprise one or more first semiconductor layers and one or more second semiconductor layers stacked in an alternating manner.

In an implementation form of the third aspect, the method further comprises epitaxially growing a multifaceted semiconductor spacer layer on the first multifaceted layer stack; and epitaxially growing a second multifaceted layer stack on the multifaceted spacer layer, wherein the second multifaceted layer stack comprises one or more first multifaceted semiconductor layers and one or more second multifaceted semiconductor layers stacked in an alternating manner.

The method of the third aspect may have implementation forms that correspond to the implementation forms of the semiconductor device of the first aspect, for example, with respect to the various materials used. The method of the third aspect achieves the same advantages as described above for the semiconductor device of the first aspect.

### BRIEF DESCRIPTION OF DRAWINGS

The above described aspects and implementation forms will be explained in the following description of specific embodiments in relation to the enclosed drawings, in which
- FIG. 1: shows two exemplary semiconductor devices according to this disclosure.
- FIG. 2: shows a method for fabricating a semiconductor device according to this disclosure.
- FIG. 3: shows two exemplary process flows for fabricating a semiconductor device according to this disclosure.
- FIG. 4: continues the two exemplary process flows shown in FIG. 3.
- FIG. 5: continues the two exemplary process flows shown in FIG. 3.
- FIG. 6: shows two exemplary process flows for fabricating a semiconductor device according to this disclosure.

### DETAILED DESCRIPTION OF EMBODIMENTS

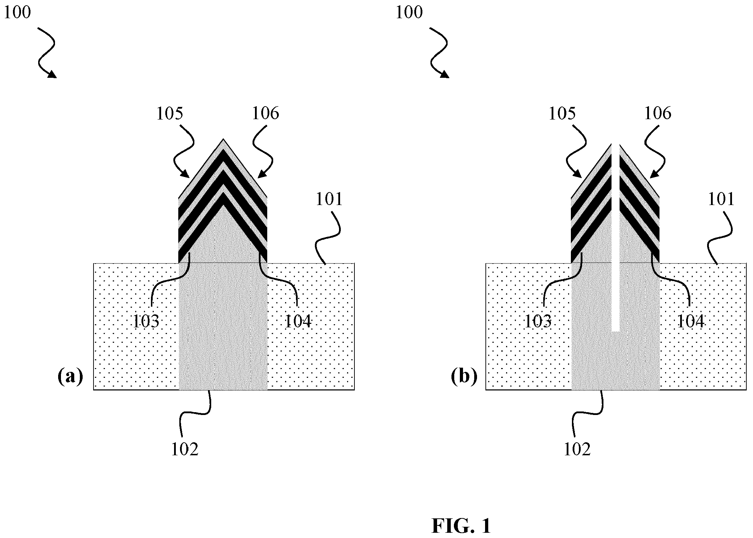

FIG. 1 shows two examples of a semiconductor device 100 according to this disclosure, one example in FIG. 1(a) and another example in FIG. 1(b). The semiconductor device 100 can be used for fabricating an integrated device. For instance, the integrated device can be a nanosheet device, a forksheet device, or a CFET device. Different process flows may be used to, respectively, fabricate such integrated devices that include the semiconductor device 100. The semiconductor device 100 may implement an n-type or p-type FET in the integrated device.

In both examples shown in FIG. 1, the semiconductor device 100 comprises a substrate layer 101, which may comprise or may be made of a silicon oxide. Further, the semiconductor device 100 comprises a semiconductor structure 102, which may comprise or may be made of crystalline silicon. Alternative materials for the semiconductor structure 102 are other silicon-based semiconductor materials or III-V semiconductor materials. The semiconductor structure 102 may be an epitaxial structure, i.e., it may be epitaxially grown. The semiconductor structure 102 is arranged partly in a trench formed in the substrate layer 101, and is partly protruding from this trench, as can be seen in FIG. 1. That is, a first part of the semiconductor structure 102 is located inside the substrate layer 101 (in the trench), while a second part of the semiconductor structure 102 is located outside the substrate layer 101 (protrudes from the trench in the substrate layer 101). In particular, the second part of the semiconductor structure 102, which protrudes from the trench, has a protruding end. The protruding end of the semiconductor structure 102 is formed by at least a first facet 103 and a second facet 104 of a semiconductor material of the semiconductor structure 102. More than these two facets are possible, as explained before. The protruding end is accordingly a multifaceted end of the semiconductor substrate 102. The first facet 103 and the second facet 104 are arranged at an angle to each other. The first facet 103 and the second facet 104 may either be both {111} crystal facets of the semiconductor material of the semiconductor substrate 102, or may be both **{311}** crystal facets of the semiconductor material of the semiconductor structure 102.

Further, the semiconductor device 100 comprises a first layer stack 105 and a second layer stack 106, which are arranged on the protruding end of the semiconductor structure 102. Thereby, the first layer stack 105 is arranged on the first facet 103, and the second layer stack 106 is arranged on the second facet 104 of the protruding end of the semiconductor structure 102. The first layer stack 105 comprises one or more first semiconductor layers and one or more second semiconductor layers stacked in an alternating manner. Likewise, the second layer stack 106 comprises one or more first semiconductor layers and one or more second semiconductor layers stacked in an alternating manner. The first semiconductor layers may be made of silicon germanium, and the second semiconductor layers may be made of silicon. Alternatively, the first semiconductor layers may be made of silicon germanium with a first germanium content, and the second semiconductor layers may be made of silicon germanium with a second germanium content that is different from the first germanium content. Alternatively, the first semiconductor material layers and the second semiconductor material layers may be based on a different semiconductor material system, e.g., a III-V semiconductor material system.

In the first example shown in FIG. 1(a), the first facet 103 and the second facet 104 are adjoining, and may thus have a common edge. In this case, the two or more semiconductor layers of the first layer stack 105 (i.e., the one or more first semiconductor layers and the one or more second semiconductor layers of the first layer stack 105) and of the two or more semiconductor layers of the second layer stack 106 (i.e., the one or more first semiconductor layers and the one or more second semiconductor layers of the second layer stack 106) are, respectively, adjoining each other. That is, each first semiconductor layer of the first layer stack 105 adjoins a first semiconductor layer of the second layer stack 106, and each second semiconductor layer of the first layer stack 105 adjoins a second semiconductor layer of the second layer stack 106. In this way, the first layer stack 105 and the second layer stack 106 may compose a multifaceted layer stack that is provided on the protruding end of the semiconductor structure 102 over both facets 103 and 104.

In the second example shown in FIG. 1(b), the first facet 103 and the second facet 104 are not adjoining, and are separated from another. Accordingly, the first facet 103 and the second facet 104 do not have or form a common edge. For example, the first facet 103 and the second facet 104 may be separated by a trench in the semiconductor structure 102 (as shown), or may be separated from each other by a dielectric material in between (could be filled in the shown trench), as explained later.

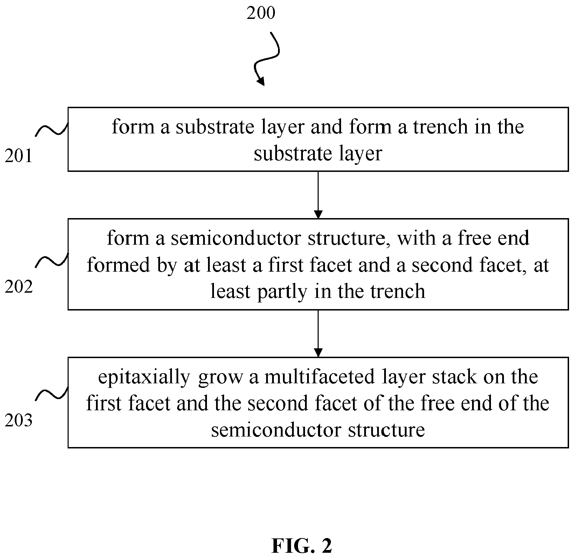

FIG. 2 shows a flow-diagram of a general method 200 for fabricating the semiconductor device 100 of this disclosure, especially that of FIG. 1. The method 200 comprises a step 201 of forming the substrate layer 101 and further forming a trench in the substrate layer 101. The substrate layer 101 may be the top part of a substrate, wherein the bottom part of the substrate may be made of crystalline semiconductor material. For instance, the trench may be etched into the substrate layer 101, wherein lithography may be used. The method 200 further comprises a step 202 of forming the semiconductor structure 102 at least partly in the trench. For example, the semiconductor structure 102 may be grown epitaxially into the trench. When forming, e.g. epitaxially growing, the semiconductor structure 102, the semiconductor structure 102 is provide with a free end. The free end is (at least at some point in time during the formation process) formed by the at least first facet 103 and second facet 104 of the semiconductor material of the semiconductor structure 102. For instance, the first facet 103 and the second facet 104 may develop automatically at some point as a result of growing the semiconductor structure 102 epitaxially into the trench.

The method 200 further comprises a step 203 of epitaxially growing a multifaceted layer stack on the first facet 103 and the second facet 104 of the free end of the semiconductor structure 102. The multifaceted layer stack may accordingly be composed of the first layer stack 105 and the second layer stack 106, as described above. The epitaxial growth may take place at the same time on at least the first facet 103 and second facet 104. The multifaceted layer stack comprises one or more first multifaceted semiconductor layers and one or more second multifaceted semiconductor layers, which are stacked in an alternating manner. This general method 200 may directly result in the semiconductor device 100 of FIG. 1(a), in which the first layer stack 105 and the second layer stack 106 constitute the multifaceted layer stack, and the first multifaceted semiconductor layers and the second multifaceted semiconductor layers constitute the first semiconductor layers and second semiconductor layers of the first layer stack 105 and the second layers tack 106, respectively.

To obtain the semiconductor device 100 of FIG. 1(b), the method 200 may further comprise a step of local etching into the multifaceted layer stack and into the semiconductor structure 102, in order to completely separate the multifaceted layer stack into the first layer stack 105 and the second layer stack 106, i.e., to separate the first layer stack 105 and the second layer stack 106 which constitute the multifaceted layer stack. The first layer stack 105 and the second layer stack 106 are the arranged on, respectively, the first facet 103 and the second facet 104.

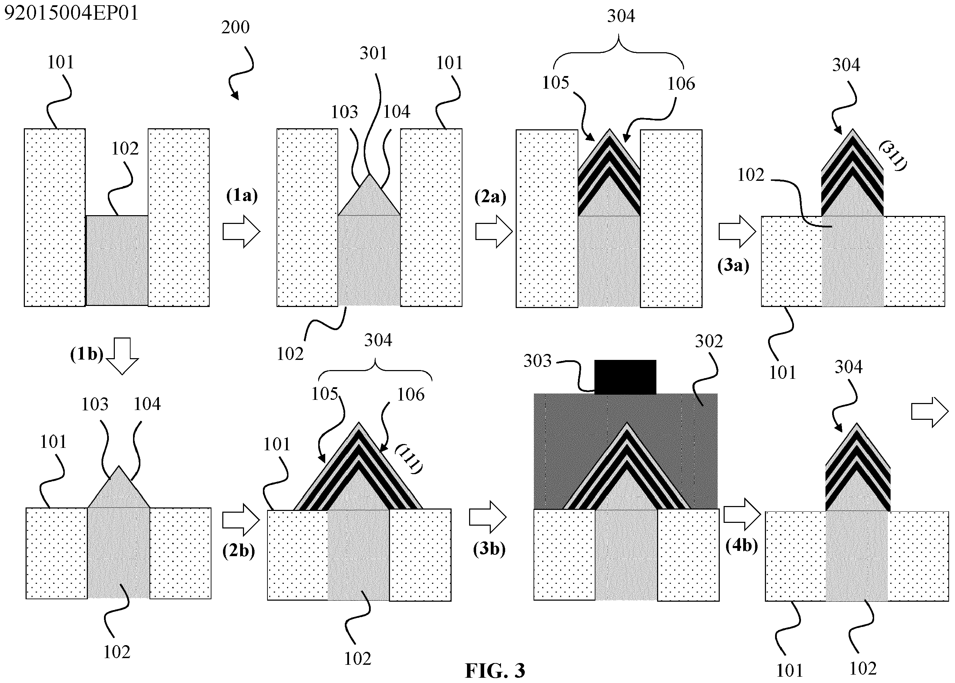

FIG. 3, FIG. 4 and FIG. 5 show two exemplary process flows, wherein these process flows may be specific implementations of the method 200 shown in FIG. 2. The two exemplary process flows may be used for fabricating the semiconductor device 100. Both exemplary process flows start with (upper left) the substrate layer 101, which may be made of silicon dioxide, and which comprises a trench into which the semiconductor structure 102 is already partly grown. The semiconductor structure 102 may be made of silicon, for example. The growth of the semiconductor structure 102 may be epitaxial, for example, it may be carried out by molecular beam epitaxy or chemical vapor deposition.

The first exemplary process flow continues with step 1a, in which the semiconductor structure 102 is further grown or formed in the trench, such that the first facet 103 and the second facet 104 are formed. For instance, the first facet 103 and the second facet 105 may form automatically due to the epitaxial growth of the semiconductor structure 102 in the trench. The first facet 103 and the second facet 104 are at this point adjoining at a common edge 301 and thus form a tip of the free end of the semiconductor structure 102. In the first exemplary process flow, the first facet 103 and the second facet 104 may particularly be **{311}** crystal facets of the semiconductor material of the semiconductor substrate 102. This semiconductor material may be silicon, or silicon-based, or a III-V semiconductor material. The first exemplary process flow continues with a step 2a, in which the first layer stack 105 and the second layer stack 106 are formed on the first facet 103 and the second facet 104, respectively, by forming a multifaceted layer stack 304 on the free end of the semiconductor substrate 102. For instance, the first layer stack 105 and the second layer stack 106 may constitute the multifaceted layer stack 304 by being adjoined to each other as described above. Specifically, each semiconductor layer of each layer stack 105 and 106 adjoins a corresponding semiconductor layer of the other layer stack 106 and 105. Notably, in this first exemplary process flow, the multifaceted layer stack 304 is formed within the trench on the free end of the semiconductor structure 102.

The first exemplary process flow continues with a step 3a, in which the substrate layer 101 is partly removed, for instance, by etching and optionally using lithography, on both sides of the semiconductor structure 102. In this way, the first facet 103, the second facet 104, and the multifaceted layer stack on these facets 103 and 104 are exposed, such that these facets 103 and 104 and the multifaceted layer stack 304 protrude from the trench formed in the substrate layer 101.

The second exemplary process flow continues from the starting point (upper left) with a step 1b, in which the substrate layer 101 is etched to be level with the semiconductor structure 101, and the semiconductor structure 102 is further grown or formed, so that the first facet 103 and the second facet 104 are formed, for instance, these facets 103 and 104 develop automatically as a result of the epitaxial growth of the semiconductor structure 102. Again, the first facet 103 and the second facet 104 are adjoining at a common edge 301 and form a tip of the free end of the semiconductor structure 102. However, unlike in the first exemplary process flow, where the first facet 103 and the second facet 103 were formed inside the trench, in the second exemplary process flow the first facet 103 and the second facet 104 protrude from the trench. In the second exemplary process flow, the first facet 103 and the second facet 104 may particularly be {111} crystal facets of the semiconductor material of the semiconductor structure 102. This semiconductor material may be silicon, or silicon-based, or a III-V semiconductor material.

The second exemplary process flow continues with a step 2b, in which the first layer stack 105 and the second layer stack 106 are formed on the first facet 103 and second facet 104, respectively, by forming a multifaceted layer stack 304 similar to the description above. This multifaceted layer stack 304 is formed on the free end of the semiconductor structure 102, which protrudes from the trench.

The second exemplary process flow continues with a step 3b, in which a spin-on-carbon (SOC) layer 302 (or similar cover layer) and a hard mask layer 303 on top of the SOC layer 302, are deposited onto the substrate layer 101 and over the semiconductor structure 102 including the multifaceted layer stack 304.

The second exemplary process flow continues with a step 4b, in which the SOC layer 302 and the hard mask layer 303 are used to etch the sides of the semiconductor structure 102 and the multifaceted layer stack 304, respectively. Also the SOC layer 302 and the hard mask layer 302 are removed afterwards.

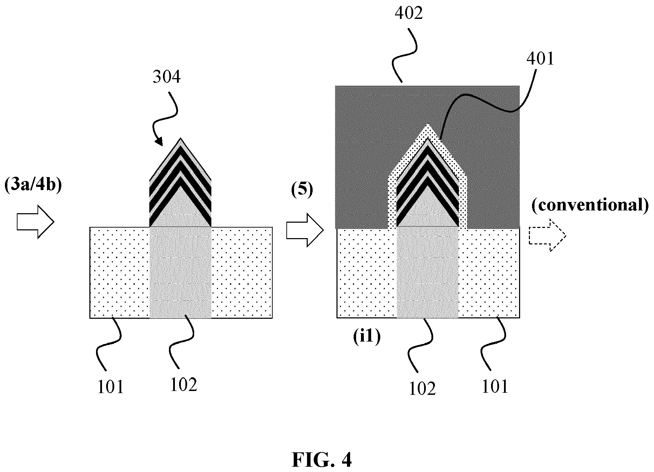

In FIG. 4 the intermediate semiconductor devices 100 resulting from step 3a of the first exemplary process flow and from step 4b of the second exemplary process flow, which are either similar or identical, are shown again. Then, both exemplary process flows of FIG. 3 continue with the common step 5, in which a dielectric layer 401 is formed. The dielectric layer 401 covers the outer surfaces of, respectively, the protruding part of the semiconductor structure 102 and the multifaceted layer stack 304 (composed of the first layer stack 105 and the second layer stack 106). Further, in step 5, a gate structure 402 is formed on the substrate layer 101, wherein the gate structure 402 surrounds the part of the semiconductor structure 102 that protrudes from the trench and the multifaceted layer stack 304 provided on the semiconductor structure 102, and the dielectric layer 401. The gate structure 402 may be made of an amorphous silicon, and may be a dummy gate structure (which may be removed in a later process step, and may be replaced by a metal gate structure). The dielectric layer 401 may be silicon oxide, or a similar material.

The process step shown in FIG. 4 may be used to fabricate an integrated device that is a nanosheet device and includes the semiconductor device 100. The process flow of FIG. 4 may then continue further, for instance, in a conventional manner. For example, process steps also used to fabricate a conventional nanosheet device may follow.

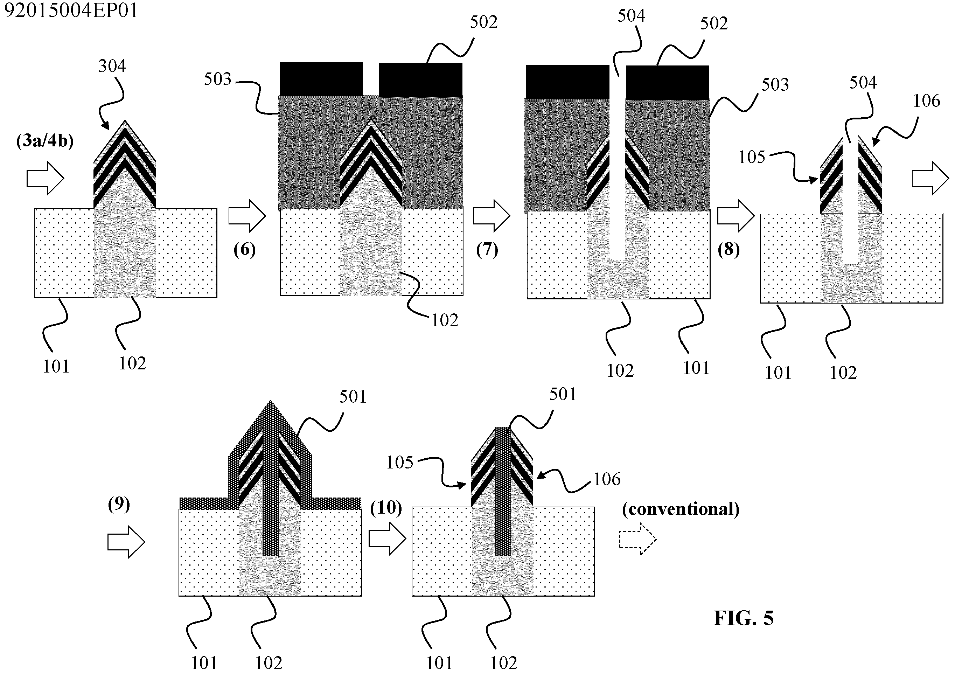

Also in FIG. 5, the intermediate semiconductor devices resulting from step 3a of the first exemplary process flow and from step 4b of the second exemplary process flow, which are either similar or identical, are shown again. Then, both exemplary process flows of FIG. 3 may optionally continue with the common steps 6 to 10 (instead of the common step 5 shown in FIG. 4).

In step 6, a SOC layer 503, and two hard mask structures 502 are formed on the substrate layer 101 and around the semiconductor structure 102 that includes the multifaceted layer stack 304 (composed of at least the first layer stack 105 and the second layer stack 106).

In step 7, the SOC layer 503 and the hard mask structures 502 are used to form a trench 504. In particular, the trench 504 may be etched into the multifaceted layer stack, and into the semiconductor structure 102, in order to completely separate the multifaceted layer stack 304 into the first layer stack 105 and the second layer stack 106, which are arranged on, respectively, the first facet 103 and the second facet 104.

In step 8, the SOC layer 503 and the hard mask structures 502 are removed. For instance, by selective etching of the SOC and/or of the hard mask material.

In step 9, a dielectric material 501 is deposited into the trench 504 and over the semiconductor structure 102 and the first layer stack 105 and second layer stack 106, which protrude from the substrate layer 101. The dielectric material 501 may be a silicon oxide, or a similar material.

In step 10, the part of the dielectric material 501, which is not formed inside the trench 504, is removed. For instance, by performing an isotropic etch, which may include lithographical patterning. Thus, the dielectric material 501 now separates the first facet 103 and the first layer stack 105 from the second facet 104 and the second layer stack 106.

The process steps shown in FIG. 5 may be used to fabricate an integrated device that is a forksheet device and includes the semiconductor device 100. The process flow of FIG. 5 may accordingly continue further, for instance, with process steps also used to fabricate a conventional forksheet device.

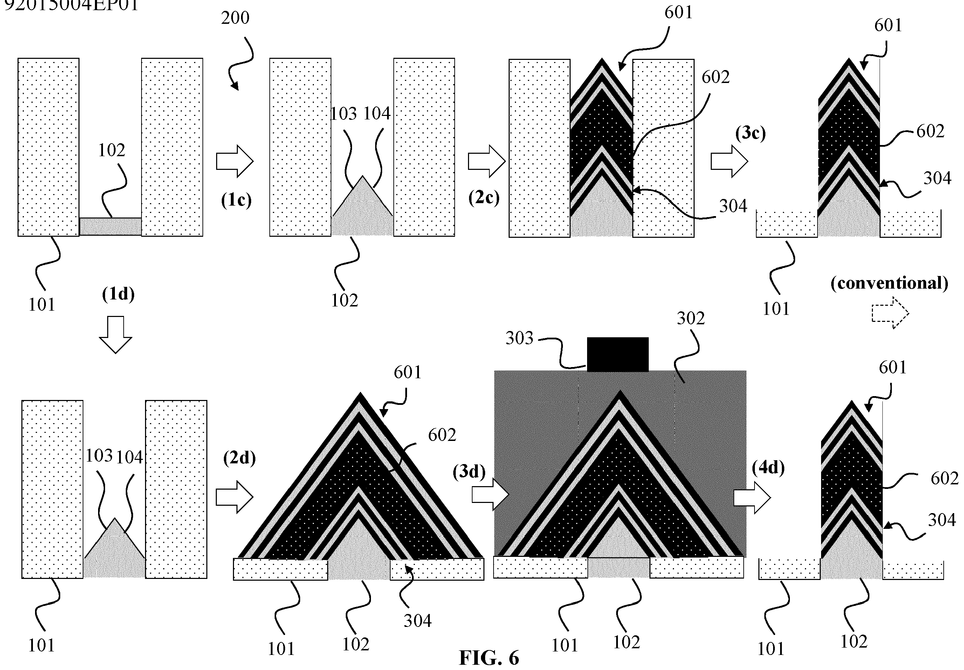

FIG. 6 shows a third exemplary process flow and a fourth exemplary process flow, both for fabricating a semiconductor device 100 according to this disclosure.

The third and fourth exemplary process flows both start (upper left) with the substrate layer 101, which can be made of a silicon dioxide, and with a part of the semiconductor structure 102 grown in a trench of the substrate layer 101. The semiconductor structure 102 may be epitaxially grown and/or may be made of crystalline silicon.

The third exemplary process flow continues with step 1c, in which the first facet 103 and the second facet 104 are formed on the semiconductor substrate 102 in the trench. This may be a consequence of the epitaxial growth of the semiconductor substrate 102, but may also be achieved in another way.

The third exemplary process flow continues with step 2c, in which a first multifaceted layer stack 304 is epitaxially grown on the first facet 103 and second facet 104, respectively, similar to what has been described above. Further, a multifaceted semiconductor spacer layer 602 is grown epitaxially on the first multifaceted layer stack 304, and a second multifaceted layer stack 601 is grown epitaxially on the multifaceted spacer layer 602. The first and the second multifaceted layer stacks 304, 601 each comprise one or more first multifaceted semiconductor layers and one or more second multifaceted semiconductor layers stacked in an alternating manner. The first multifaceted semiconductor layers may be made of silicon germanium with a germanium content in a range of 15-20%. The multifaceted semiconductor spacer layer 602 may be made of silicon germanium with a germanium content in a range of 25-50%. The second multifaceted semiconductor spacer layers may be made of silicon.

The third exemplary process flow continues with step 3c, in which the substrate layer 101 is etched on both sides of the semiconductor substrate 102, and of the multifaceted layer stacks 304, 601, and of the multifaceted semiconductor spacer layer 602, in order to expose these components, and such that they protrudes from the substrate layer 101.

The fourth exemplary process flow continues with step 1d, in which the first facet 103 and the second facet 104 are formed on the semiconductor substrate 102 in the trench. The step 1d is similar to step 1c.

The fourth exemplary process flow continues with step 2d, in which first the substrate layer 101 is etched, such that the semiconductor substrate 102 with the first facet 103 and the second facet 104 protrudes from the substrate layer 101. Then, the first multifaceted layer stack 304, the multifaceted semiconductor spacer layer 602, and the second multifaceted layer stack 601 are grown on the protruding end of the semiconductor structure 102.

The fourth exemplary process flow continues with step 3d, in which a SOC layer 302 and a hard mask layer 303 are formed on the substrate layer 101 and over the semiconductor substrate 102 with the multifaceted layer stacks and the multifaceted spacer layer 304, 601, 602, respectively .

The fourth exemplary process flow continues with step 4d, in which the substrate layer 101 is etched on both sides of the semiconductor substrate 102, the multifaceted layer stacks 304, 601, and the multifaceted semiconductor spacer layer 602, in order to form a pillar or fin shaped structure. Thus, these multifaceted layer stacks 304, 601 and the multifaceted semiconductor spacer layers 602 are narrowed, wherein a similar structure as resulting from step 3c of the third exemplary process flow is obtained.

The third and fourth exemplary process flows can be used to fabricate an integrated device that is a CFET device and comprises the semiconductor device 100. For example, both the third exemplary process flow and the fourth exemplary process flow may then continue with process steps as also used in a conventional monolithic CFET device production method.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A semiconductor device comprising:
a substrate layer;
a semiconductor structure arranged partly in a trench formed in the substrate layer and partly protruding from the trench,
wherein a protruding end of the semiconductor structure is formed by at least a first facet and a second facet of a semiconductor material of the semiconductor structure, wherein the first facet and the second facet are arranged at an angle to each other; and
an first epitaxial layer stack and a second epitaxial layer stack arranged on the protruding end of the semiconductor structure,
wherein the first epitaxial layer stack and the second epitaxial layer stack each comprise one or more first semiconductor layers and one or more second semiconductor layers stacked in an alternating manner, and wherein the first epitaxial layer stack is arranged on the first facet and the second epitaxial layer stack is arranged on the second facet of the protruding end of the semiconductor structure.

2. The semiconductor device according to claim 1, wherein the semiconductor structure is a silicon-based structure, and wherein the first facet and the second facet are both {111} crystal facets or are both {311} crystal facets of the silicon-based material of the silicon-based structure.

3. The semiconductor device according to claim 1 or 2, wherein the first facet and the second facet are adjoining at a common edge and/or form a tip of the protruding end of the semiconductor structure.

4. The semiconductor device according to one of the claims 1 to 3, wherein the two or more semiconductor layers of the first epitaxial layer stack and the two or more semiconductor layers of the second epitaxial layer stack are, respectively, adjoining each other and form a first multifaceted layer stack, which comprises one or more first multifaceted semiconductor layers and one or more second multifaceted semiconductor layers stacked in an alternating manner.

5. The semiconductor device according to claim 3 or 4, further comprising a multifaceted semiconductor spacer layer arranged on the first multifaceted layer stack, and a second multifaceted layer stack arranged on the multifaceted spacer layer, wherein the second multifaceted layer stack comprises one or more first multifaceted semiconductor layers and one or more second multifaceted semiconductor layers stacked in an alternating manner.

6. The semiconductor device according to claim 1 or 2, further comprising a dielectric material that separates the first facet and the first epitaxial layer stack from the second facet and the second epitaxial layer stack.

7. The semiconductor device according to one of the claims 1 to 6, wherein:
the first semiconductor layers are made of silicon germanium, and the second semiconductor layers are made of silicon; or
wherein the first semiconductor layers are made of silicon germanium with a first germanium content, and the second semiconductor layers are made of silicon germanium with a second germanium content different from the first germanium content.

8. The semiconductor device according to the claims 7 and 5, wherein the first semiconductor layers are made of silicon germanium with a germanium content in a range of 15-20%, and the multifaceted semiconductor spacer layer is made of silicon germanium with a germanium content in a range of 25-50%.

9. The semiconductor device according to one of the claim 1 to 8, wherein the semiconductor structure is made of crystalline silicon.

10. The semiconductor device according to one of the claims 1 to 9, wherein the substrate layer comprises silicon oxide.

11. The semiconductor device according to one of the claims 1 to 10, further comprising a dielectric layer, which covers the outer surfaces of the protruding part of the semiconductor structure and each epitaxial layer stack, respectively.

12. The semiconductor device according to one of the claims 1 to 11, further comprising a gate structure arranged on the substrate layer and surrounding part of the semiconductor structure that protrudes from the trench and each epitaxial layer stack.

13. An integrated device comprising a semiconductor device, wherein:
the integrated device is a nanosheet device and the semiconductor device is according to claim 3 or 4; or
the integrated device is a forksheet device and the semiconductor device is according to claim 6; or
the integrated device is a complementary field effect transistor, CFET, device and the semiconductor device is according to claim 5 or 8.

14. A method for fabricating a semiconductor device, the method comprising:
forming a substrate layer and a trench in the substrate layer;
forming a semiconductor structure at least partly in the trench,
wherein the semiconductor structure has a free end formed by at least a first facet and a second facet of a semiconductor material of the semiconductor structure; and
epitaxially growing a multifaceted layer stack on the first facet and the second facet of the free end of the semiconductor structure,
wherein the multifaceted layer stack comprises one or more first multifaceted semiconductor layers and one or more second multifaceted semiconductor layers stacked in an alternating manner.

15. The method according to claim 14, wherein:
the multifaceted layer stack is formed within the trench on the free end of the semiconductor structure; or
the multifaceted layer stack is formed on the free end, which protrudes from the trench.

16. The method according to claim 14 or 15, further comprising:
etching into the multifaceted layer stack and into the semiconductor structure to completely separate the multifaceted layer stack into a first layer stack and a second layer stack arranged on, respectively, the first facet and the second facet,
wherein the first layer stack and the second layer stack each comprise one or more first semiconductor layers and one or more second semiconductor layers stacked in an alternating manner.

17. The method according to claim 14 or 15, further comprising:
epitaxially growing a multifaceted semiconductor spacer layer on the first multifaceted layer stack; and
epitaxially growing a second multifaceted layer stack on the multifaceted spacer layer,
wherein the second multifaceted layer stack comprises one or more first multifaceted semiconductor layers and one or more second multifaceted semiconductor layers stacked in an alternating manner.

## Amended claims

### Amended claims in accordance with Rule 137(2) EPC.

1. An intermediate semiconductor device comprising:
a substrate layer;
a semiconductor structure arranged partly in a trench formed in the substrate layer and partly protruding from the trench,
wherein a protruding end of the semiconductor structure is formed by three or more facets of a semiconductor material of the semiconductor structure, wherein the three or more facets are each arranged at an angle to each other; and
an first epitaxial layer stack and a second epitaxial layer stack arranged on the protruding end of the semiconductor structure,
wherein the first epitaxial layer stack and the second epitaxial layer stack each comprise one or more first semiconductor layers and one or more second semiconductor layers stacked in an alternating manner, and wherein the first epitaxial layer stack is arranged on a first facet of the three or more facets and the second epitaxial layer stack is arranged on a second facet of the three or more facets of the protruding end of the semiconductor structure.

2. The intermediate semiconductor device according to claim 1, wherein the semiconductor structure is a silicon-based structure, and wherein the first facet and the second facet are both **{111}** crystal facets or are both **{311}** crystal facets of the silicon-based material of the silicon-based structure.

3. The intermediate semiconductor device according to claim 1 or 2, wherein the first facet and the second facet are adjoining at a common edge and/or form a tip of the protruding end of the semiconductor structure.

4. The intermediate semiconductor device according to one of the claims 1 to 3, wherein the two or more semiconductor layers of the first epitaxial layer stack and the two or more semiconductor layers of the second epitaxial layer stack are, respectively, adjoining each other and form a first multifaceted layer stack, which comprises one or more first multifaceted semiconductor layers and one or more second multifaceted semiconductor layers stacked in an alternating manner.

5. The intermediate semiconductor device according to claim 3 or 4, further comprising a multifaceted semiconductor spacer layer arranged on the first multifaceted layer stack, and a second multifaceted layer stack arranged on the multifaceted spacer layer, wherein the second multifaceted layer stack comprises one or more first multifaceted semiconductor layers and one or more second multifaceted semiconductor layers stacked in an alternating manner.

6. The intermediate semiconductor device according to claim 1 or 2, further comprising a dielectric material that separates the first facet and the first epitaxial layer stack from the second facet and the second epitaxial layer stack.

7. The intermediate semiconductor device according to one of the claims 1 to 6, wherein:
the first semiconductor layers are made of silicon germanium, and the second semiconductor layers are made of silicon; or
wherein the first semiconductor layers are made of silicon germanium with a first germanium content, and the second semiconductor layers are made of silicon germanium with a second germanium content different from the first germanium content.

8. The intermediate semiconductor device according to the claims 7 and 5, wherein the first semiconductor layers are made of silicon germanium with a germanium content in a range of 15-20%, and the multifaceted semiconductor spacer layer is made of silicon germanium with a germanium content in a range of 25-50%.

9. The intermediate semiconductor device according to one of the claim 1 to 8, wherein the semiconductor structure is made of crystalline silicon.

10. The intermediate semiconductor device according to one of the claims 1 to 9, wherein the substrate layer comprises silicon oxide.

11. The intermediate semiconductor device according to one of the claims 1 to 10, further comprising a dielectric layer, which covers the outer surfaces of the protruding part of the semiconductor structure and each epitaxial layer stack, respectively.

12. The intermediate semiconductor device according to one of the claims 1 to 11, further comprising a gate structure arranged on the substrate layer and surrounding part of the semiconductor structure that protrudes from the trench and each epitaxial layer stack.

13. An integrated device comprising an intermediate semiconductor device, wherein:
the integrated device is a nanosheet device and the intermediate semiconductor device is according to claim 3 or 4; or
the integrated superstructure is a forksheet superstructure and the intermediate semiconductor device is according to claim 6; or
the integrated device is a complementary field effect transistor, CFET, device and the intermediate semiconductor device is according to claim 5 or 8.

14. A method for fabricating an intermediate semiconductor device, the method comprising:
forming a substrate layer and a trench in the substrate layer;
forming a semiconductor structure at least partly in the trench,
wherein the semiconductor structure has a free end formed by three or more facets of a semiconductor material of the semiconductor structure; and
epitaxially growing a multifaceted layer stack on a first facet of the three or more facets and a second facet of the three or more facets of the free end of the semiconductor structure,
wherein the multifaceted layer stack comprises one or more first multifaceted semiconductor layers and one or more second multifaceted semiconductor layers stacked in an alternating manner.

15. The method according to claim 14, wherein:
the multifaceted layer stack is formed within the trench on the free end of the semiconductor structure; or
the multifaceted layer stack is formed on the free end, which protrudes from the trench.

16. The method according to claim 14 or 15, further comprising:
etching into the multifaceted layer stack and into the semiconductor structure to completely separate the multifaceted layer stack into a first layer stack and a second layer stack arranged on, respectively, the first facet and the second facet,
wherein the first layer stack and the second layer stack each comprise one or more first semiconductor layers and one or more second semiconductor layers stacked in an alternating manner.

17. The method according to claim 14 or 15, further comprising:
epitaxially growing a multifaceted semiconductor spacer layer on the first multifaceted layer stack; and
epitaxially growing a second multifaceted layer stack on the multifaceted spacer layer,
wherein the second multifaceted layer stack comprises one or more first multifaceted semiconductor layers and one or more second multifaceted semiconductor layers stacked in an alternating manner.
